# EUROPEAN PATENT SPECIFICATION

(11) **EP 3 719 610 B1**
(45) Date of publication and mention of the grant of the patent: **21.08.2024**
(21) Application number: 20160814.8
(22) Date of filing: 03.03.2020
(51) Int. Cl.: G06F 1/16, G02F 1/1362, H04M 1/02

(54) **ELECTRONIC DEVICE INCLUDING DISPLAY**
ELEKTRONISCHE VORRICHTUNG MIT ANZEIGE
DISPOSITIF ÉLECTRONIQUE COMPRENANT UN AFFICHAGE

(30) Priority: 03.04.2019 KR 20190038832
(43) Date of publication of application: 07.10.2020
(73) Proprietor: Samsung Electronics Co., Ltd., Suwon-si, Gyeonggi-do 16677 (KR)
(72) Inventor: MOON, Chanyoung, Suwon-si, Gyeonggi-do, 16677 (KR); KWAK, Hokeun, Suwon-si, Gyeonggi-do, 16677 (KR); SEO, Jungpa, Suwon-si, Gyeonggi-do, 16677 (KR); HER, Yongkoo, Suwon-si, Gyeonggi-do, 16677 (KR); YEOM, Donghyun, Suwon-si, Gyeonggi-do, 16677 (KR); WON, Jonghoon, Suwon-si, Gyeonggi-do, 16677 (KR); LEE, Kihuk, Suwon-si, Gyeonggi-do, 16677 (KR)
(74) Representative: HGF

(56) References cited:
- EP-A1- 3 226 101
- EP-A1- 3 428 967
- EP-A1- 3 553 638
- WO-A1-2019/024695
- TW-A- 201 835 887
- TW-B- I 664 615
- US-A1- 2020 034 100

## Description

### BACKGROUND

### 1. Field

The disclosure relates to an electronic device including a display. More particularly, the disclosure relates to a device having multiple coaxial areas around the center of a lens each having varied wire density and pixel density to control the amount of light traveling into the lens.

### 2. Description of the Related Art

Electronic devices, for example, mobile electronic devices have been used in various fields closely connected with our life with technological development. Such electronic devices are manufactured in various sizes in accordance with the functions and preferences of users and may include a large-screen touch display for securing wide visibility and convenient operation. Electronic devices have been developed in the direction of relatively expanding the display area more than other electronic devices even if they have the same size.

An electronic device may include a display that can be seen from the outside through at least a portion of a front plate (e.g., a window or a front cover). In order to satisfy the requirement for a large screen, the areas of displays are being increased so that the displays can be exposed through the entire area of front plates. As a consequence of expansion of a display area, the arrangement structure of various electronic parts disposed to be able to detect the external environment through a front plate, for example, at least one camera device or various sensors (e.g., an illumination sensor, an iris sensor, an ultrasonic sensor, or an infrared sensor) is also unavoidably changed. This is because if the electronic parts are disposed in a black matrix (BM) area outside the display area of a front plate, there is a limit in expanding the display area.

In order to expand a display area and smoothly dispose an electronic part, a display may have an opening (e.g., a punch hole or a bored hole) at a position corresponding to the electronic part (e.g., a camera module). The electronic part can be disposed close to the rear side of a front plate at least partially through the opening of the display and can perform its function.

The front plate may have a printed area surrounding a camera exposure area to hide a stacked structure, a machined portion, or an internal structure such as wires around the opening of the display that may be seen through the camera exposure area from the outside. However, such a printed area may not only increase the portion that a camera disposition area occupies, but also deteriorate the external design together with the camera exposure area in a large-screen display.

The above information is presented as background information only, and to assist with an understanding of the disclosure. No determination has been made, and no assertion is made, as to whether any of the above might be applicable as prior art with regard to the disclosure.

EP 3 553 638 A1 discloses an electronic device including: a sensor, a display panel including a sensor area overlaying or underlying the sensor and a pixel area including at least one pixel and a drive wiring line configured to drive the at least one pixel while surrounding the sensor area, a window disposed over the display panel, and one or more opaque members disposed between the sensor and the window and along an edge of the sensor area.

EP 3 226 101 A1 discloses an electronic device including a housing, comprising a first surface including a transparent later and a second surface, a display exposed through the transparent layer and including an active area, a first adhesive layer, a touchscreen panel, and a second adhesive layer, an opening formed at least partially through the first adhesive layer, a plurality of conductive lines disposed extending around a periphery of the opening so as not to optically block the opening, a camera device positioned including an image sensor disposed through at least a portion of the opening, and an integrated circuit (IC) electrically coupled to the plurality of conductive lines, wherein the IC is configured to provide image data to the display.

TW 201 835 887 A discloses a display screen and an electronic terminal. The display screen includes a display region including a first display area and a second display area. The first display area has a screen as a first screen, and the second display area has a screen as a second screen. A light transmittance of the first screen is greater than a light transmittance of the second screen. The electronic terminal includes a terminal body, the above display screen, a front device and a control device. The above display screen and electronic terminal can improve the full screen display effect.

WO 2019/024695 A1 discloses an optical assembly, which is applied to a mobile terminal including a camera, and includes: a cover plate, an optical clear glue, a polarizer, and a display panel; wherein the cover plate passes through the optical clear glue Adhere to the first surface of the polarizer, and the second surface of the polarizer is adhered to the first surface of the display panel; the cover plate can transmit light, and the polarizer is opposite to the camera The position is provided with a first through hole, the display panel is provided with a target area at a position opposite to the camera; the display panel includes a display substance, and the target area does not include the display substance.

EP3428967 A1 discloses an electronic device comprising a display and a front camera.

### SUMMARY

Aspects of the disclosure are to address at least the above-mentioned problems and/or disadvantages, and to provide at least the advantages described below. Accordingly, an aspect of the disclosure is to provide an electronic device including a display.

Another aspect of the disclosure is to provide an electronic device that may be disposed such that a camera module can operate through a display even though an opening is not formed at a display panel.

Another aspect of the disclosure is to provide an electronic device including a display in which a camera exposure area can be reduced by omitting a printed area.

Additional aspects will be set forth in part in the description which follows and, in part, will be apparent from the description, or may be learned by practice of the presented embodiments.

The present invention is defined by the independent claims. Further aspects of the present invention are outlined in the dependent claims. When the term "embodiment" is used herein for describing an unclaimed combination of features, it has to be understood as referring to an example useful for understanding the present invention.

Other aspects, advantages, and salient features of the disclosure will become apparent to those skilled in the art from the following detailed description, which, taken in conjunction with the annexed drawings, discloses various embodiments of the disclosure.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a front perspective view of a mobile electronic device according to an embodiment of the disclosure;
FIG. 2 is a perspective view showing the rear side of the electronic device of FIG. 1 according to an embodiment of the disclosure;
FIG. 3 is an exploded perspective view of the electronic device of FIG. 1 according to an embodiment of the disclosure;
FIG. 4 is a separate perspective view showing a stacked structure of a display according to an embodiment of the disclosure;
FIG. 5 is a partial cross-sectional view of the electronic device taken along line A-A' of FIG. 1 according to an embodiment of the disclosure;
FIG. 6 is a view showing a disposition configuration of a display according to an embodiment of the disclosure;
FIGS. 7A and 7B are views showing a wire disposition configuration in a second area of a display panel according to various embodiments of the disclosure;
FIG. 8 is a view showing a state in which a portion of a second area of a display panel is disposed in a light path of a lens according to an embodiment of the disclosure;
FIG. 9 is a graph showing transmittance for each field of a lens according to a surrounding light quantity according to an embodiment of the disclosure;
FIGS. 10A and 10B are views illustrating a wire density and a pixel density in a second area of a display panel according to a lens designed in accordance with a surrounding light quantity according to various embodiments of the disclosure; and
FIGS. 11A, 11B, and 11 C are views showing stacked structures of a display according to various embodiments of the disclosure.

Throughout the drawings, it should be noted that like reference numbers are used to depict the same or similar elements, features, and structures.

### DETAILED DESCRIPTION

The following description with reference to the accompanying drawings is provided to assist in a comprehensive understanding of various embodiments of the disclosure as defined by the claims. It includes various specific details to assist in that understanding but these are to be regarded as merely exemplary. Accordingly, those of ordinary skill in the art will recognize that various changes and modifications of the various embodiments described herein can be made without departing from the scope of the disclosure. In addition, descriptions of well-known functions and constructions may be omitted for clarity and conciseness.

The terms and words used in the following description and claims are not limited to the bibliographical meanings, but are merely used to enable a clear and consistent understanding of the disclosure. Accordingly, it should be apparent to those skilled in the art that the following description of various embodiments of the disclosure is provided for illustration purpose only and not for the purpose of limiting the disclosure as defined by the appended claims.

It is to be understood that the singular forms "a," "an," and "the" include plural referents unless the context clearly dictates otherwise. Thus, for example, reference to "a component surface" includes reference to one or more of such surfaces.

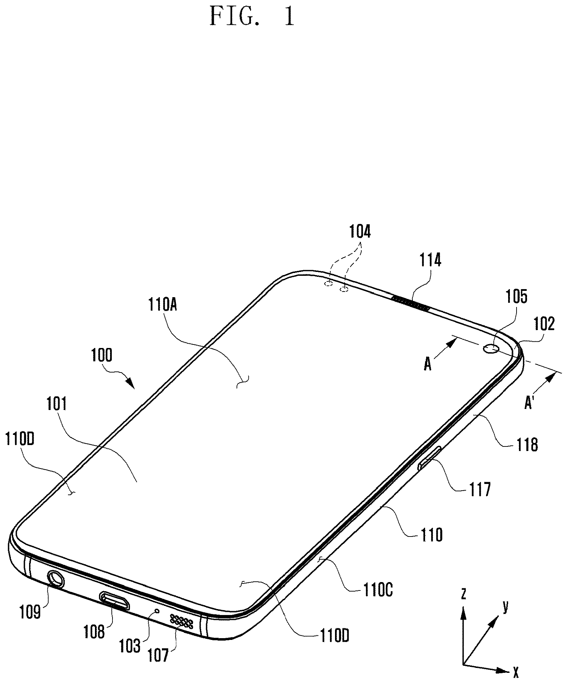

FIGS. 1 to 11C, discussed below, and the various embodiments used to describe the principles of the disclosure in this patent document are by way of illustration only and should not be construed in any way to limit the scope of the disclosure. Those skilled in the art will understand that the principles of the disclosure may be implemented in any suitably arranged system or device.

Hereinafter, embodiments of the disclosure are described in detail with reference to accompanying drawings.

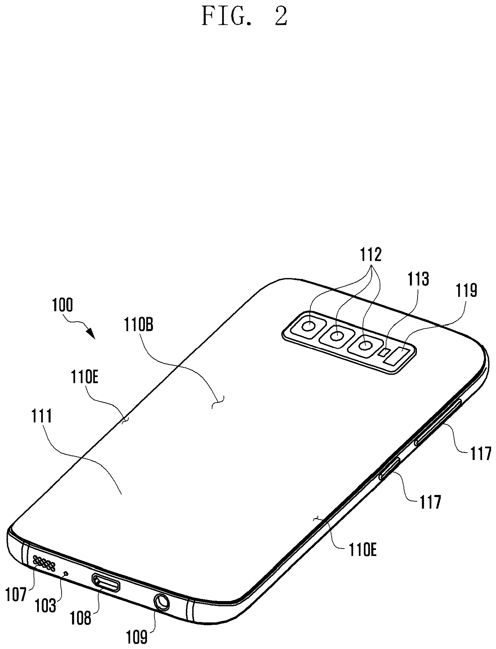

FIG. 1 illustrates a perspective view showing a front surface of a mobile electronic device according to an embodiment of the disclosure, and FIG. 2 illustrates a perspective view showing a rear surface of the mobile electronic device shown in FIG. 1 according to an embodiment of the disclosure.

Referring to FIGS. 1 and 2, a mobile electronic device 100 may include a housing 110 that includes a first surface (or front surface) 110A, a second surface (or rear surface) 110B, and a lateral surface 110C that surrounds a space between the first surface 110A and the second surface 110B. The housing 110 may refer to a structure that forms a part of the first surface 110A, the second surface 110B, and the lateral surface 110C. The first surface 110A may be formed of a front plate 102 (e.g., a glass plate or polymer plate coated with a variety of coating layers) at least a part of which is substantially transparent. The second surface 110B may be formed of a rear plate 111 which is substantially opaque. The rear plate 111 may be formed of, for example, coated or colored glass, ceramic, polymer, metal (e.g., aluminum, stainless steel (STS), or magnesium), or any combination thereof. The lateral surface 110C may be formed of a lateral bezel structure (or "lateral member") 118 which is combined with the front plate 102 and the rear plate 111 and includes a metal and/or polymer. The rear plate 111 and the lateral bezel structure 118 may be integrally formed and may be of the same material (e.g., a metallic material such as aluminum).

The front plate 102 may include two first regions 110D disposed at long edges thereof, respectively, and bent and extended seamlessly from the first surface 110A toward the rear plate 111. Similarly, the rear plate 111 may include two second regions 110E disposed at long edges thereof, respectively, and bent and extended seamlessly from the second surface 110B toward the front plate 102. The front plate 102 (or the rear plate 111) may include only one of the first regions 110D (or of the second regions 110E). The first regions 110D or the second regions 110E may be omitted in part. When viewed from a lateral side of the mobile electronic device 100, the lateral bezel structure 118 may have a first thickness (or width) on a lateral side where the first region 110D or the second region 110E is not included, and may have a second thickness, being less than the first thickness, on another lateral side where the first region 110D or the second region 110E is included.

The mobile electronic device 100 may include at least one of a display 101, audio modules 103, 107 and 114, sensor modules 104 and 119, camera modules 105, 112 and 113, a key input device 117, a light emitting device, and connector holes 108 and 109. The mobile electronic device 100 may omit at least one (e.g., the key input device 117 or the light emitting device) of the above components, or may further include other components.

The display 101 may be exposed through a substantial portion of the front plate 102, for example. At least a part of the display 101 may be exposed through the front plate 102 that forms the first surface 110A and the first region 110D of the lateral surface 110C. Outlines (i.e., edges and corners) of the display 101 may have substantially the same form as those of the front plate 102. The spacing between the outline of the display 101 and the outline of the front plate 102 may be substantially unchanged in order to enlarge the exposed area of the display 101.

A recess or opening may be formed in a portion of a display area of the display 101 to accommodate at least one of the audio module 114, the sensor module 104, the camera module 105, and the light emitting device. At least one of the audio module 114, the sensor module 104, the camera module 105, a fingerprint sensor (not shown), and the light emitting element may be disposed on the back of the display area of the display 101. The display 101 may be combined with, or adjacent to, a touch sensing circuit, a pressure sensor capable of measuring the touch strength (pressure), and/or a digitizer for detecting a stylus pen. At least a part of the sensor modules 104 and 119 and/or at least a part of the key input device 117 may be disposed in the first region 110D and/or the second region 110E.

The audio modules 103, 107 and 114 may correspond to a microphone hole 103 and speaker holes 107 and 114, respectively. The microphone hole 103 may contain a microphone disposed therein for acquiring external sounds and, in a case, contain a plurality of microphones to sense a sound direction. The speaker holes 107 and 114 may be classified into an external speaker hole 107 and a call receiver hole 114. The microphone hole 103 and the speaker holes 107 and 114 may be implemented as a single hole, or a speaker (e.g., a piezo speaker) may be provided without the speaker holes 107 and 114.

The sensor modules 104 and 119 may generate electrical signals or data corresponding to an internal operating state of the mobile electronic device 100 or to an external environmental condition. The sensor modules 104 and 119 may include a first sensor module 104 (e.g., a proximity sensor) and/or a second sensor module (e.g., a fingerprint sensor) disposed on the first surface 110A of the housing 110, and/or a third sensor module 119 (e.g., a heart rate monitor (HRM) sensor) and/or a fourth sensor module (e.g., a fingerprint sensor) disposed on the second surface 110B of the housing 110. The fingerprint sensor may be disposed on the second surface 110B as well as the first surface 110A (e.g., the display 101) of the housing 110. The electronic device 100 may further include at least one of a gesture sensor, a gyro sensor, an air pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 105, 112 and 113 may include a first camera device 105 disposed on the first surface 110A of the electronic device 100, and a second camera device 112 and/or a flash 113 disposed on the second surface 110B. The camera module 105 or the camera module 112 may include one or more lenses, an image sensor, and/or an image signal processor. The flash 113 may include, for example, a light emitting diode or a xenon lamp. Two or more lenses (infrared cameras, wide angle and telephoto lenses) and image sensors may be disposed on one side of the electronic device 100.

The key input device 117 may be disposed on the lateral surface 110C of the housing 110. The mobile electronic device 100 may not include some or all of the key input device 117 described above, and the key input device 117 which is not included may be implemented in another form such as a soft key on the display 101. The key input device 117 may include the sensor module disposed on the second surface 110B of the housing 110.

The light emitting device may be disposed on the first surface 110A of the housing 110. For example, the light emitting device may provide status information of the electronic device 100 in an optical form. The light emitting device may provide a light source associated with the operation of the camera module 105. The light emitting device may include, for example, a light emitting diode (LED), an IR LED, or a xenon lamp.

The connector holes 108 and 109 may include a first connector hole 108 adapted for a connector (e.g., a universal serial bus (USB) connector) for transmitting and receiving power and/or data to and from an external electronic device, and/or a second connector hole 109 adapted for a connector (e.g., an earphone jack) for transmitting and receiving an audio signal to and from an external electronic device.

Some sensor modules 105 of camera modules 105 and 212, some sensor modules 104 of sensor modules 104 and 119, or an indicator may be arranged to be exposed through a display 101. For example, the camera module 105, the sensor module 104, or the indicator may be arranged in the internal space of an electronic device 100 so as to be brought into contact with an external environment through an opening of the display 101, which is perforated up to a front plate 102. In another embodiment, some sensor modules 104 may be arranged to perform their functions without being visually exposed through the front plate 102 in the internal space of the electronic device. For example, in this case, an area of the display 101 facing the sensor module may not require a perforated opening.

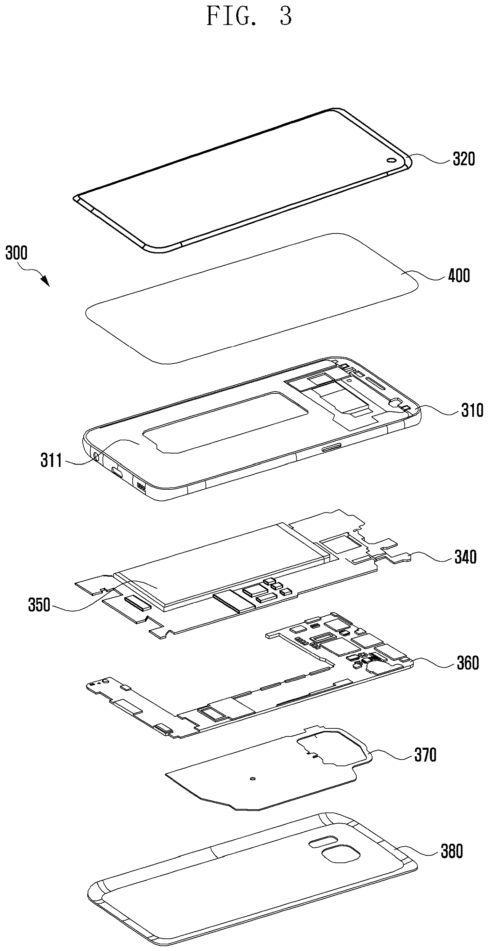

FIG. 3 illustrates an exploded perspective view showing a mobile electronic device shown in FIG. 1 according to an embodiment of the disclosure.

Referring to FIG. 3, a mobile electronic device 300 may include a lateral bezel structure 310, a first support member 311 (e.g., a bracket), a front plate 320, a display 400, an electromagnetic induction panel (not shown), a printed circuit board (PCB) 340, a battery 350, a second support member 360 (e.g., a rear case), an antenna 370, and a rear plate 380. The mobile electronic device 300 may omit at least one (e.g., the first support member 311 or the second support member 360) of the above components or may further include another component. Some components of the electronic device 300 may be the same as or similar to those of the mobile electronic device 100 shown in FIG. 1 or FIG. 2, thus, descriptions thereof are omitted below.

The first support member 311 is disposed inside the mobile electronic device 300 and may be connected to, or integrated with, the lateral bezel structure 310. The first support member 311 may be formed of, for example, a metallic material and/or a non-metal (e.g., polymer) material. The first support member 311 may be combined with the display 400 at one side thereof and also combined with the printed circuit board (PCB) 340 at the other side thereof. On the PCB 340, a processor, a memory, and/or an interface may be mounted. The processor may include, for example, one or more of a central processing unit (CPU), an application processor (AP), a graphics processing unit (GPU), an image signal processor (ISP), a sensor hub processor, or a communications processor (CP).

The memory may include, for example, one or more of a volatile memory and a non-volatile memory.

The interface may include, for example, a high definition multimedia interface (HDMI), a USB interface, a secure digital (SD) card interface, and/or an audio interface. The interface may electrically or physically connect the mobile electronic device 300 with an external electronic device and may include a USB connector, an SD card/multimedia card (MMC) connector, or an audio connector.

The battery 350 is a device for supplying power to at least one component of the mobile electronic device 300, and may include, for example, a non-rechargeable primary battery, a rechargeable secondary battery, or a fuel cell. At least a part of the battery 350 may be disposed on substantially the same plane as the PCB 340. The battery 350 may be integrally disposed within the mobile electronic device 300, and may be detachably disposed from the mobile electronic device 300.

The antenna 370 may be disposed between the rear plate 380 and the battery 350. The antenna 370 may include, for example, a near field communication (NFC) antenna, a wireless charging antenna, and/or a magnetic secure transmission (MST) antenna. The antenna 370 may perform short-range communication with an external device, or transmit and receive power required for charging wirelessly. An antenna structure may be formed by a part or combination of the lateral bezel structure 310 and/or the first support member 311.

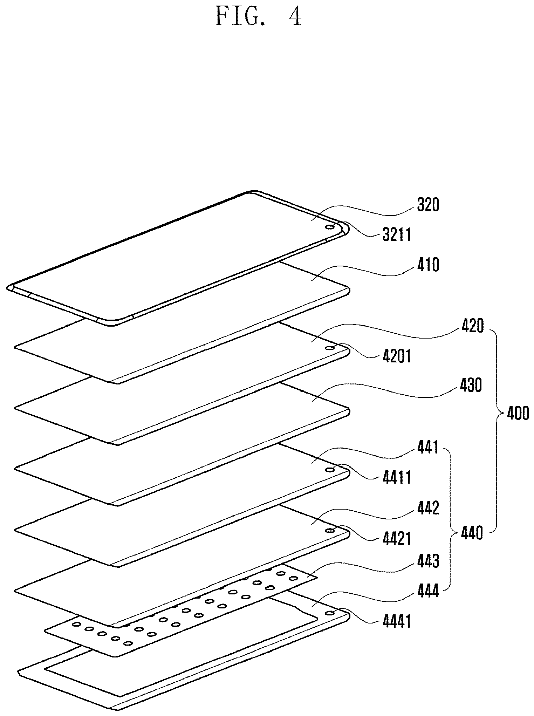

FIG. 4 is a separate perspective view showing a stacked structure of a display according to an embodiment of the disclosure.

A display 400 of FIG. 4 may be at least partially similar to the display 101 of FIG. 1 or the display 400 of FIG. 3, or may further include other embodiments of a display.

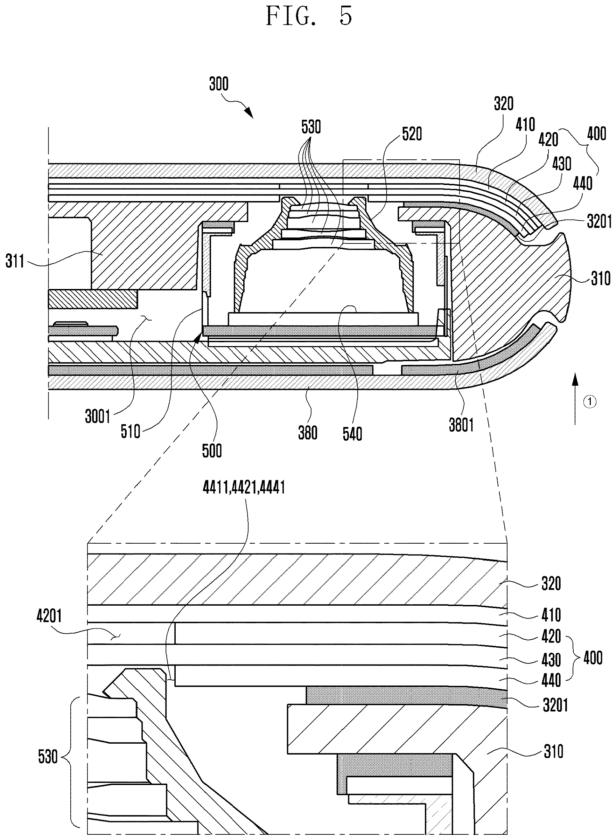

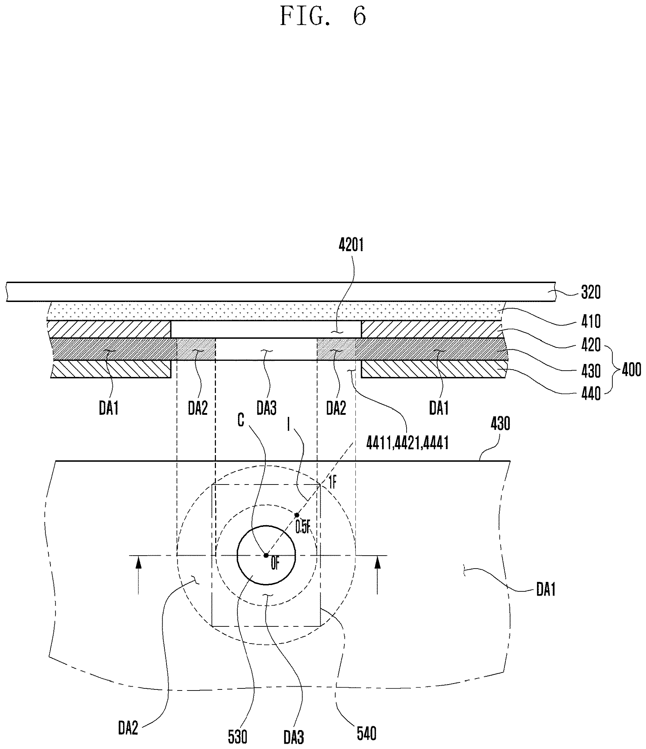

Referring to FIG. 4, the display 400 may include a polarizer (POL) 420, a display panel 430, and/or a subsidiary material layer 440 disposed through an adhesive layer 410 on a front plate 320 (e.g., the front plate 102 of FIG. 1). According to an embodiment, the front plate 320 may have a camera exposure area 3211 disposed at a position corresponding to a camera module (e.g., a camera module 500 of FIG. 5). According to an embodiment, a printed area may be omitted in the camera exposure area 3211. The camera exposure area 3211 may substantially include a second area (e.g., the second area DA2 in FIG. 6) of the display panel 430 to be described below. According to an embodiment, the adhesive layer 410 may have an optical clear adhesive (OCA), a pressure sensitive adhesive (PSA), a thermally reactive adhesive, a normal adhesive, or a double-sided tape. According to an embodiment, the POL 420 can selectively pass light that is generated from a light source of the display panel 430 and vibrates in a predetermined direction. According to an embodiment, the display panel 430 and the POL 420 may be integrally formed. According to an embodiment, the display 400 may include a touch panel. Though not shown, the display panel 430 may include a control circuit. According to an embodiment, the control circuit may include a display driver IC (DDI) and/or a touch display driver IC (TDDI) that is disposed in a chip-on-panel (COP) or chip-on-film (COF) type. As another embodiment, the display 400 may include a fingerprint sensor disposed around the control circuit. According to an embodiment, the fingerprint sensor may include an ultra or optical fingerprint sensor that can sense the fingerprint of a finger that touches or comes close to the outer surface of the front plate 320 through holes at least partially formed at some of the components of the display 400.

According to various embodiments, the subsidiary material layer 440 may include one or more polymer members 441 and 442 and/or one or more functional members 443 and 444. According to an embodiment, the polymer members 441 and 442 may include an embossed layer 441 that removes bubbles, which may be produced between the display panel 430 and the attachments thereunder, and/or a cushion layer 442 disposed to attenuate shock. According to an embodiment, the one or more functional members 443 and 444 may include a graphite sheet 443 for heat dissipation and/or a conductive member 444 for dissipating heat and/or blocking noise. According to an embodiment, the conductive member 444 may include Copper (CU), Aluminum (Al), Stainless Steel (SUS), or clad material (CLAD) (e.g., a stacked member in which SUS and A1 are alternately disposed). As another embodiment, at least one functional member may include an added display, a force touch flexible printed circuit board (FPCB), a fingerprint sensor FPCB, a communication antenna emitter, a heat dissipation sheet, a conductive/nonconductive tape, or an open cell sponge. As another embodiment, the display 400 may further include a detector for detecting input by an electromagnetic induction type writer. According to an embodiment, the detector may include a digitizer.

According to various embodiments, the electronic device (e.g., an electronic device 300 of FIG. 3) includes a camera module (the camera module 500 of FIG. 5) disposed under the display 400 when viewing the front plate 320 from above. According to an embodiment, the POL 420 may have an opening 4201 overlapping at least the camera module (e.g., the camera module 500 of FIG. 5) when viewing the front plate 320 from above. According to an embodiment, the subsidiary material layer 440 may also have openings 4411, 4421, and 4441 overlapping at least the camera module (e.g., the camera module 500 of FIG. 5) when viewing the front plate 320 from above. According to an embodiment, the display panel 430 may not have any opening when viewing the front plate 320 from above. According to an embodiment, any wire structure and/or pixel structure may not be disposed in at least some area of the display panel 430, unlike the surrounding display area. According to an embodiment, at least some area of the display panel 430 may have a wire density and/or a pixel density that is different from that of the surrounding display area. According to an embodiment, at least some area of the display panel 430 may be formed to have a wire density and/or a pixel density that is lower than that of the surrounding display area. According to an embodiment, the area of the display panel 430 that has a relatively low wire density and/or pixel density can perform a display function and can be used as at least some area in which the angle of view of a camera module disposed thereunder. According to an embodiment, the area of the display panel 430 that has a relatively low wire density and/or pixel density can perform a shield function that hides the stacked structure, the machined portion, or the internal structure such as wires of the display 400. Accordingly, a specific printed area may not be formed on the rear side of the front plate 320, whereby the camera exposure area of the front plate 320 may be reduced.

FIG. 5 is a partial cross-sectional view of the electronic device taken along line A-A' of FIG. 1 according to an embodiment of the disclosure.

Referring to FIG. 5, the electronic device 300 may include a front plate 320 (e.g., a first plate or a front window) facing a first direction (direction ①), a rear plate 380 (e.g., a second plate or a rear window) facing an opposite direction to front plate 320, and a side member 310 surrounding a space 3001 between the front plate 320 and the rear plate 380. According to an embodiment, the electronic device 300 may include a first waterproof member 3201 disposed between the subsidiary material layer 440 of the display 400 and the side member 310. According to an embodiment, the electronic device 300 may include a second waterproof member 3801 disposed between the side member 310 and the rear plate 380. The first waterproof member 3201 and the second waterproof member 3801 can prevent external dirt or water from entering an internal space 3001 of the electronic device 300.

According to various embodiments, the side member 310 may further include a support member 311 extending at least partially into the internal space 3001 of the electronic device 300. According to an embodiment, the support member 311 may be formed by structural combination with the side member 310. According to an embodiment, the support member 311 can support the camera module 500 such that the camera module 500 is disposed through the openings 4411, 4421, and 4441 of the subsidiary layer 440 of the display 400 and positioned close to the rear side of the display panel 430.

According to various embodiments, the camera module 500 may include a camera housing 510, a barrel 520 at least partially protruding from the camera housing 510, and one or more lenses 530 disposed with predetermined gaps inside the barrel 520 and/or at least one image sensor 540 disposed to be aligned with the one or more lenses 530 in the internal space of the camera housing 510.

According to various embodiments, the electronic device 300 may include an adhesive layer 410, a POL 420, a display panel 430, and/or a subsidiary material layer 440 disposed between the rear side of the front plate 320 and the side member 310. According to an embodiment, when viewing the front plate 320 from above, the POL 420 may have an opening 4201 formed in an area overlapping the one or more lenses 530 to improve optical transmittance of the camera module 500. As another embodiment, the adhesive layer 410 disposed over the POL 420 may also be partially omitted. According to an embodiment, when viewing the front plate 320 from above, the subsidiary material layer 440 may have openings 4411, 4421, and 4441 formed in an area overlapping at least the barrel 520. According to an embodiment, an angle of view is secured by disposing the one or more lenses 530 of the camera module 500 close to the display panel 430 through the openings 4411, 4421, and 4441, whereby it is possible to greatly contribute to reducing a transparent area (e.g., a third area DA3 of FIG. 6) of the display panel 430 that overlaps the lenses 530.

According to various embodiments, the display panel 430 may not have any opening even in any area overlapping the camera module 500 when viewing the front plate 320 from above. According to an embodiment, the display panel 430 may be configured to at least partially have different wire densities and/or pixel densities. According to an embodiment, the display panel 430 may have an area (a second area DA2 of FIG. 6) that has a wire density and/or pixel density substantially lower than that of the display area, and this area may be replaced with a printed area that may be defined on the rear side of the front plate 320.

FIG. 6 is a view showing a disposition configuration of a display according to an embodiment of the disclosure.

Referring to FIG. 6, the display 400 may include the POL 420, the display panel 430, and/or the subsidiary material layer 440 disposed through the adhesive layer 410 on the rear side of the front plate 320. According to an embodiment, the display 400 may have openings 4201, 4411, 4421, and 4441 formed at the POL 420 and the subsidiary material layer 440 except for the display panel 430.

According to various embodiments, when viewing the front plate 320 from above, the display panel 430 having an area overlapping the one or more lenses 530 may be divided into various areas. According to an embodiment, the various areas may be coaxial areas DA1, DA2, and DA3 around the center C of the lenses 530. According to an embodiment, when viewing the front plate 320 from above, the distance of a virtual straight line 'l' from the center C (e.g., OF) of the lenses 530 (e.g., the center of the image sensor) to a diagonal corner of the image sensor 540 (e.g., 1F) may be defined as 1F (field). In this case, the display panel 430, when viewing the front plate 320 from above, may have a first area DA1 coaxially defined around the center C of the lenses 530 (or the center of the image sensor 540), a second area DA2 surrounded by the first area DA1, and a third area DA3 surrounded by the second area DA2 and including the lens center C. According to an embodiment, the second area DA2 and the third area DA3 may be defined at positions overlapping at least the openings 4201, 4411, 4421, and 4441 when viewing the front plate 320 from above.

According to various embodiments, the first area DA1 may include a substantial display area disposed outside a circle having 1F from the lens center C as a radius. According to an embodiment, the first area DA1 may have a first wire density and a first pixel density. According to an embodiment, the second area DA2 has the area of an annulus having 0.5F as small radius and 1 F as large radius. According to an embodiment, the second area DA2 may extend from the first area DA1. According to an embodiment, the second area DA2 may have a second wire density and/or a second pixel density lower than that of the first area DA1. According to an embodiment, the second wire density and/or the second pixel density of the second area DA may be determined in accordance with lens design values considering a surrounding light amount. According to an embodiment, the third area DA3, which is a transparent area (e.g., a camera exposure area) where the angle of view of a lens is substantially formed, may have a circular area having the range of 0F to 0.5F as a radius. According to an embodiment, the third area DA3 may extend from the second area DA2. According to an embodiment, the third area DA3 may not have any wire disposition structure or pixel disposition structure. As another embodiment, the third area DA3 may have a third wire density and/or a third pixel density lower than that of the second area DA2.

According to various embodiments, when viewing the front plate 320 from above, the stacked structure, machined portion, or the internal structure such as wires of the display 400 that may be seen through a camera exposure area can be visually blocked by the second area DA2 of the display panel 430. According to an embodiment, the second area DA2 of the display panel 430 may be seen as a display area extending from a surrounding display area (e.g., the first area DA1) by the wire structure and the pixel structure.

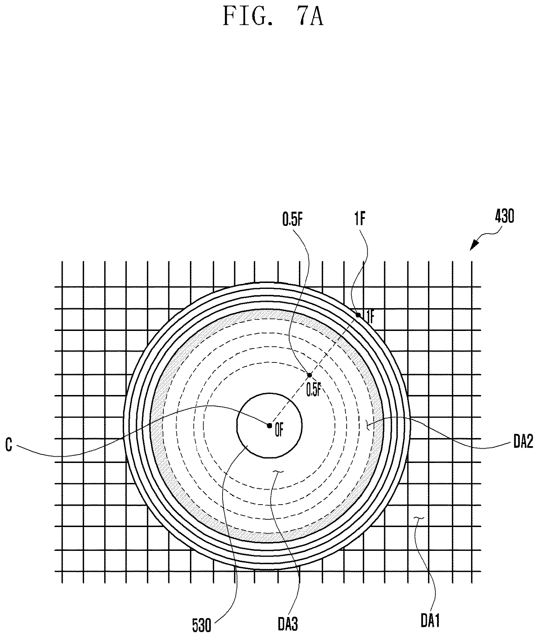

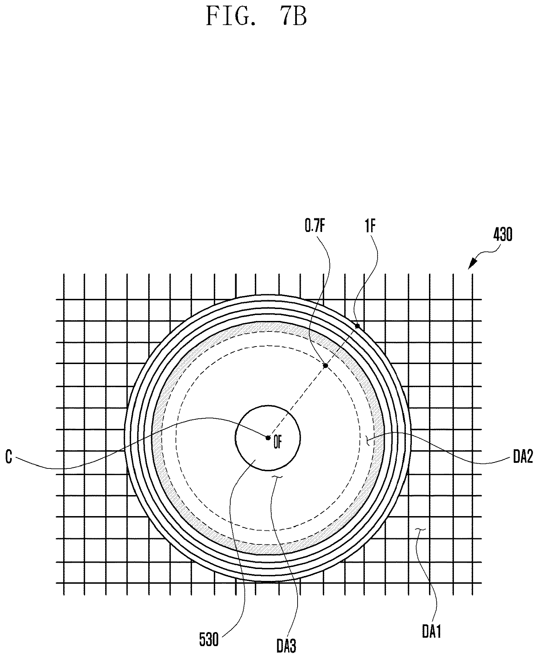

FIGS. 7A and 7B are views showing a wire disposition configuration in a second area of a display panel according to various embodiments of the disclosure.

Referring to FIG. 7A, the second area DA2 of the display panel 430 has the area of an annulus having 0.5 F as small radius and 1 F as large radius. According to an embodiment, the wire density of the second area DA2 may be lower than the wire density of the first area DA1. In this case, the second area DA2 surrounded by the first area DA1 may have a camera exposure area that can be visually seen from a front plate (e.g., the front plate 320 of FIG. 6).

Referring to FIG. 7B, the second area DA2 of the display panel 430 may have the area of a circle having the range of 0.7F to 1F as a radius. According to an embodiment, the wire density of the second area DA2 may be lower than the wire density of the first area DA1. In this case, the second area DA2 surrounded by the first area DA1 may have a camera exposure area that can be visually seen from a front plate (e.g., the front plate 320 of FIG. 6). According to an embodiment, the third area DA3 has an area larger than the third area DA3 of FIG. 7A, which may be advantageous in defining the angle of view of a lens (e.g., the lens 530 of FIG. 5).

According to various embodiments, wires and pixels may be disposed in the second area DA2 with a wire density and a pixel density lower than those of the first area DA1. According to an embodiment, the pixel density of the second area DA2 is a low pixel density in comparison to the first area DA1.

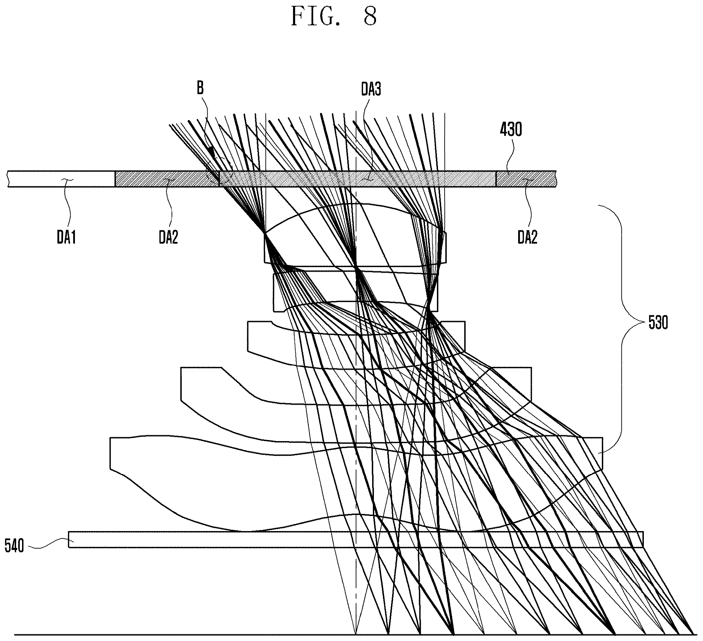

FIG. 8 is a view showing a state in which a portion of a second area of a display panel is disposed in a light path of a lens according to an embodiment of the disclosure.

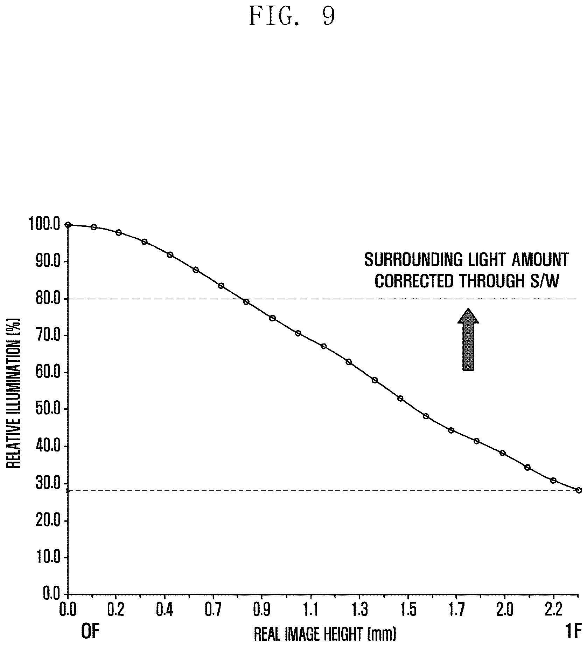

FIG. 9 is a graph showing transmittance for each field of a lens according to a surrounding light quantity according to an embodiment of the disclosure.

Referring to FIG. 8, the display panel 430 has a first area DA1 substantially including a display area, a second area DA2 surrounded by the first area DA1 and having a pixel density lower than that of the first area DA1, and a third area DA3 surrounded by the second area DA2 and being a transparent area including the light path of the lens 530.

According to various embodiments, like area B shown in the figure, at least a portion of the second area DA2 may be disposed to invading the light path of the lens 530. This is because the smaller the second area DA2, the smaller the camera exposure area, which can be visually seen from the outside of a front plate (e.g., the front plate 320 of FIG. 6), can be.

Referring to FIG. 9, the amount of light traveling into the lens 530 may decrease, but optical transmittance can be compensated under a predetermined light amount by correcting a surrounding light amount using software (S/W) of an electronic device.

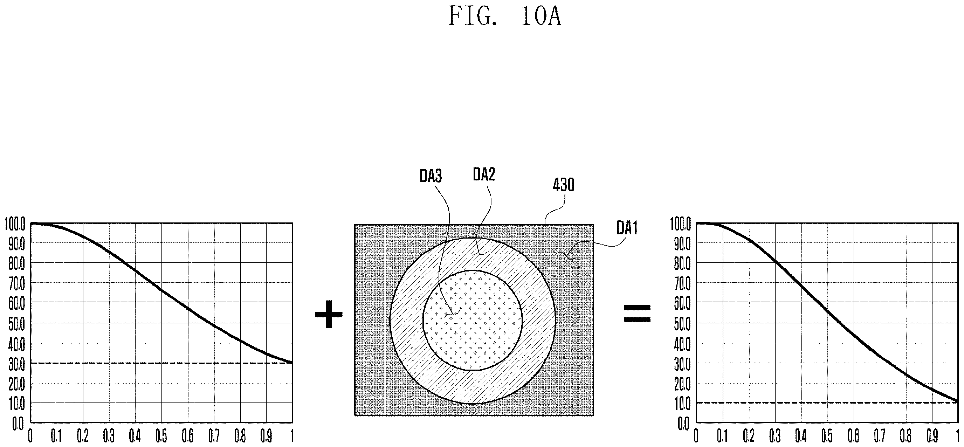

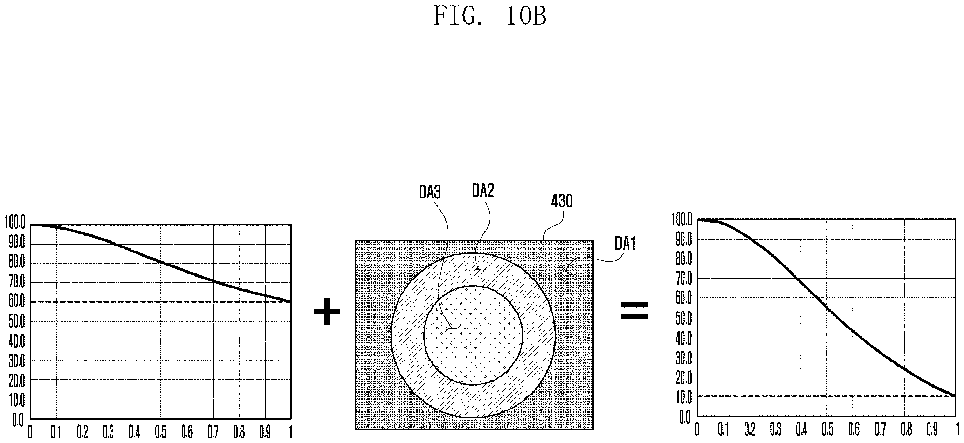

FIGS. 10A and 10B are views illustrating a wire density and a pixel density in a second area of a display panel according to a lens designed in accordance with a surrounding light quantity according to various embodiments.

According to various embodiments, the wire density and/or pixel density of the second area DA2 of the display panel 430 may be determined in accordance with lens design values according to a surrounding light amount.

Referring to FIG. 10A, if a lens is designed to have optical transmittance from 0F to 1F of the display panel 430 defined as minimum 30%, the wire density and/or pixel density of the second area DA2 may be about 66% of the wire density and/or pixel density of the second area DA2 of the first area DA1 when the minimum available optical transmittance (e.g., the minimum transmittance that can be compensated for by correction using S/W) is about 10%.

Referring to FIG. 10B, if a lens is designed to have optical transmittance from 0F to 1F of the display panel 430 defined as minimum 60%, the wire density and/or pixel density of the second area DA2 may be about 83% of the wire density and/or pixel density of the first area DA1 when the minimum available optical transmittance is about 10%.

Accordingly, the wire density and/or the pixel density of the second area DA2 may be defined with a proportion smaller than 1-(0.1/surrounding light amount).

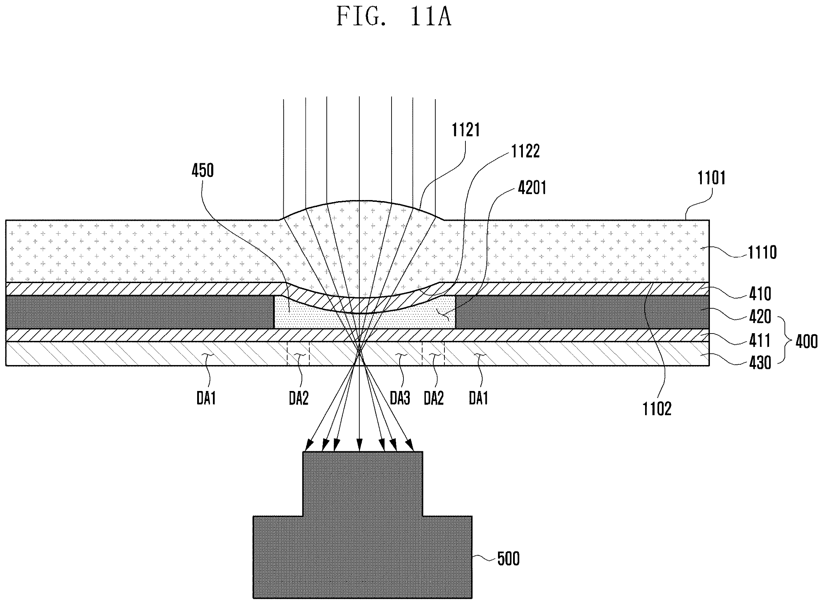

FIGS. 11A to 11C are views showing stacked structures of a display according to various embodiments.

Referring to FIG. 11A, the display 400 disposed on the rear side of a front plate 1110 through the first adhesive layer 410 may include the POL 420, a second adhesive layer 411, and/or the display panel 430. Though not shown, the display 400 may further include a subsidiary material layer (e.g., the subsidiary material layer 440 of FIG. 5) additionally stacked on the display panel 430. According to an embodiment, when viewing the front plate 1110 from above, the POL 420 may have the opening 4201 formed at a position overlapping the camera module 500 to prevent a decrease of transmittance. According to an embodiment, since the opening 4201 is formed by removing a portion of the POL 420, the removed area may be seen due to reflection of the display panel 430, so the opening 4201 may be filled with an index matching material 450. According to an embodiment, the index matching material 450 filling the opening 4201 can suppress a decrease of optical transmittance due to reflection of the display panel 430.

According to various embodiments, the front plate 1110 may have a first surface 1101 facing the outside and a second surface 1102 (e.g., a rear side) facing the first surface 1101. According to an embodiment, when viewing the front plate 1110 from above, the front plate 1110 may have one or more curved portions 1121 and 1122 protruding outward in the area overlapping the camera module 500. According to an embodiment, the centers of the one or more curved portions 1121 and 1122 may be positioned to overlap the center of the lens (e.g., the lens 530 of FIG. 5) of the camera module 500 when viewing the front plate 1110 from above. According to an embodiment, the one or more curved portions 1121 and 1122 may have a first curved portion 1121 protruding outward from the first surface 1101 and a second curved portion 1122 protruding from the second surface 1102. According to an embodiment, the focus of the lens (e.g., the lens 530 of FIG. 5) of the camera module 500 may be formed through the first curved portion 1121 and the second curved portion 1122 of the front plate 1110.

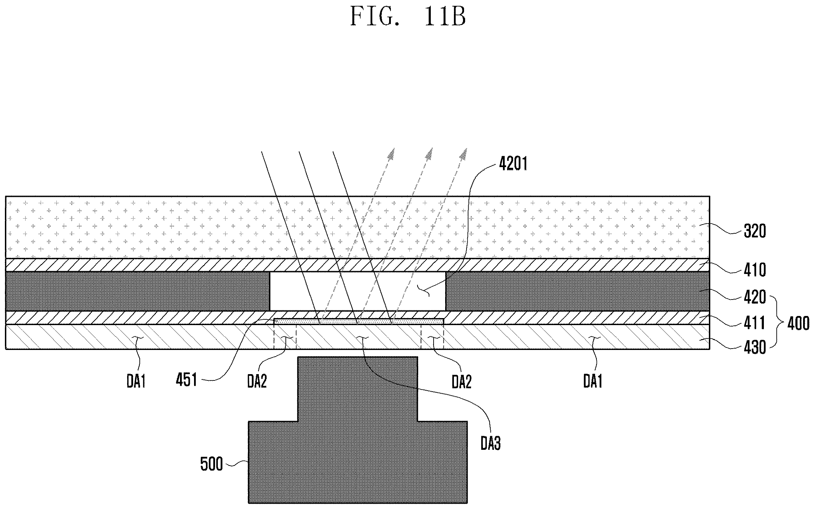

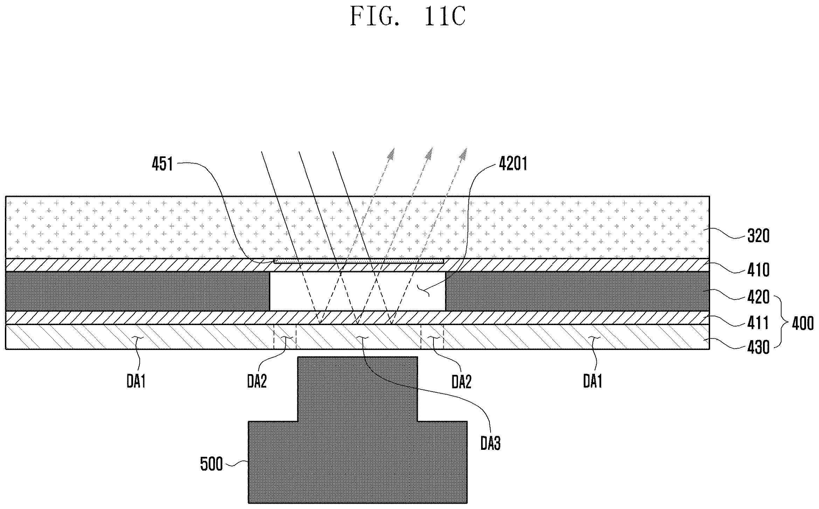

Referring to FIGS. 11B and 11C, since the opening 4201 is formed by removing a portion of the POL 420 and the removed portion can be seen by reflection of the display panel 430, a decrease of optical transmittance due to reflection of the display panel 430 can be suppressed by a translucent coating material 451 disposed through the first adhesive layer 410 and/or the second adhesive layer 411. According to an embodiment, when viewing the front plate 320 from above, the translucent coating material 451 may be disposed at a position overlapping the second area DA2 and the third area DA3 overlapping the camera module 500, on the first adhesive layer 410 and/or the second adhesive layer 411. According to an embodiment, the transmittance of the display panel may be determined by the translucent coating material.

According to various embodiments, even though a camera module is disposed under a display, an opening is not formed in the corresponding area, so it may be advantageous in terms of manufacturing a display. Further, a printed area that is defined on a front plate is removed by adjusting the wire density and/or pixel density in some area of the display, so a camera exposure area can be reduced.

According to various embodiments, an electronic device (e.g., the electronic device 300 of FIG. 3) includes a front plate (e.g., the front plate 320 of FIG. 3), a display panel (e.g., the display panel 430) disposed in an internal space (e.g., the internal space 3001 of FIG. 3) of the electronic device visible through at least a portion of the front plate, and a camera module (e.g., the camera module 500 of FIG. 3) disposed in the internal space and including an image sensor (e.g., the image sensor 540 of FIG. 3) disposed close to the display panel. The display panel may have a first area (e.g., the first area DA1 of FIG. 6) having a first wire density and/or a first pixel density, a second area (e.g., the second area DA2 of FIG. 6) surrounded by the first area and having a second wire density lower than the first wire density and/or a second pixel density lower than the first pixel density, and a third area (e.g., the third area DA3 of FIG. 6) surrounded by the second area DA2 and at least partially overlapping the center of the image sensor when viewing the front plate from above.

According to various embodiments, if the distance of a virtual straight line (e.g., the virtual straight line 'l' of FIG. 6) from the center of the image sensor to a diagonal corner of the image sensor is defined as 1F, the second area includes an annulus area having 0.5 F as small radius and 1 F as large radius.

According to various embodiments, the wire density and/or the pixel density of the second area may be determined in accordance with a lens design value of the camera module considering a surrounding light amount.

According to various embodiments, the wire density and/or the pixel density of the second area DA2 may be determined with a proportion smaller than 1-(0.1/surrounding light amount).

According to various embodiments, the electronic device may further include a polarizer (POL) (e.g., the POL 420 of FIG. 3) disposed between the front plate and the display panel and the POL may have a first opening (e.g., the opening 4201 of FIG. 3) formed at a position overlapping at least the camera module when viewing the front plate from above.

According to various embodiments, when viewing the front sheet from above, the first opening may be disposed at a position overlapping the second area and the third area when viewing the front plate from above.

According to various embodiments, the first opening may be disposed at a position partially overlapping at least a portion of the first area.

According to various embodiments, the first opening may be filled with an index matching material (e.g., the index matching material 450 of FIG. 11A) to improve visibility of a removed portion of the display panel according to reflection.

According to various embodiments, when viewing the front plate from above, the front plate may have a curved portion (e.g., the curved portions 1121 and 1122 of FIG. 11A) protruding outward in the area overlapping the opening.

According to various embodiments, the electronic device may include a first adhesive layer (e.g., the first adhesive layer 410 of FIG. 11B) disposed between the front plate and the POL and a second adhesive layer (e.g., the second adhesive plate 411 of FIG. 11B) disposed between the POL and the display panel.

According to various embodiments, the first adhesive layer and/or the second adhesive layer may include at least one of an optical clear adhesive (OCA), a pressure sensitive adhesive (PSA), a thermally reactive adhesive, a normal adhesive, or a double-sided tape.

According to various embodiments, the first adhesive layer and/or the second adhesive layer may further include a translucent coating material (e.g., the translucent coating material 451 of FIG. 11A) at least partially disposed to improve visibility of a removed area of the display panel.

According to various embodiments, the translucent coating material overlaps the second area and the third area when viewing the front plate from above.

According to various embodiment, the electronic device further includes at least one subsidiary material layer disposed on the rear side of the display panel and the subsidiary material layer may have a second opening overlapping at least the camera module when viewing the front plate from above.

According to various embodiments, the camera module may be disposed to be close to or to be in contact with the display panel through the second opening.

According to various embodiments, the subsidiary material layer may include at least one polymer (e.g., the polymer members 441 and 442 of FIG. 3) disposed on the rear side of the display panel and at least one functional member (e.g., the functional members 443 and 444 of FIG. 3) disposed on the rear side of the polymer member.

According to various embodiments, the at least one polymer member may include an embossed layer and/or a cushion layer.

As another embodiment, at least one functional member may include at least one of a graphite sheet, a conductive plate, an added display, a force touch FPCB, a fingerprint sensor FPCB, a communication antenna emitter, a heat dissipation sheet, a conductive/nonconductive tape, or an open cell sponge.

According to various embodiments, the second opening may be disposed at a position overlapping the second area and the third area when viewing the front plate from above.

According to various embodiments, the second opening may be disposed at a position partially overlapping at least a portion of the first area when viewing the front sheet from above.

While the disclosure has been shown and described with reference to various embodiments thereof, it will be understood by those skilled in the art that various changes in form and details may be made therein without departing from the scope of the disclosure as defined by the appended claims.

## Claims

1. An electronic device (300) comprising:
a front plate (320);
a display panel disposed in an internal space (3001) of the electronic device (300) visible through at least a portion of the front plate (320); and
a camera module (500) disposed in the internal space (3001) and including an image sensor (540) disposed close to the display panel,
wherein the display panel comprises:
a first area (DA1) having a first pixel density,
a second area (DA2) surrounded by the first area (DA1) and having a second pixel density lower than the first pixel density, and
a third area (DA3) surrounded by the second area (DA2) and at least partially overlapping a center of the image sensor (540) when viewing the front plate (320) from above, wherein the third area (DA3) having a third pixel density lower than the second pixel density;
wherein the third area comprises a camera exposure area where an angle of view of a lens of the camera module is substantially formed,
wherein the second pixel density of the second area is determined as a proportion of the first pixel density of the first area smaller than 1-(0.1/minimum optical transmittance of a lens (530) of the camera module (500));
wherein when a distance of a virtual straight line from the center of the image sensor (540) to a diagonal corner of the image sensor (540) is defined as 1 F, the second area (DA2) is an annulus area having 0.5 F as a small radius and 1 F as a large radius

2. The electronic device (300) of claim 1, further comprising a polarizer (POL) disposed between the front plate (320) and the display panel,
wherein the POL has a first opening formed at a position overlapping at least the camera module (500) when viewing the front plate (320) from above.

3. The electronic device (300) of claim 2, wherein the first opening is disposed at a position overlapping the second area (DA2) and the third area (DA3) when viewing the front plate (320) from above.

4. The electronic device (300) of claim 2, wherein the first opening is disposed at a position partially overlapping at least a portion of the first area (DA1) when viewing the front plate (320) from above.

5. The electronic device (300) of claim 2, wherein the first opening is filled with an index matching material to suppress a decrease of optical transmittance caused by reflection of the display panel.

6. The electronic device (300) of claim 2, wherein the front plate (320) has a curved portion protruding outward in an area overlapping the opening when viewing the front sheet from above.

7. The electronic device (300) of claim 2, further comprising:
a first adhesive layer disposed between the front plate (320) and the POL; and
a second adhesive layer disposed between the POL and the display panel.

8. The electronic device (300) of claim 7, wherein at least one of the first adhesive layer or the second adhesive layer comprise at least one of an optical clear adhesive (OCA), a pressure sensitive adhesive (PSA), a thermally reactive adhesive, a normal adhesive, or a double-sided tape.

9. The electronic device (300) of claim 7, wherein at least one of the first adhesive layer or the second adhesive layer further comprise a translucent coating material at least partially disposed to suppress a decrease of optical transmittance due to reflection of the display panel.

10. The electronic device (300) of claim 9, wherein the translucent coating material overlaps the second area (DA2) and the third area (DA3) when viewing the front plate (320) from above.

11. The electronic device (300) of claim 1, further comprising at least one subsidiary material layer disposed on the rear side of the display panel,
wherein the subsidiary material layer has a second opening overlapping at least the camera module (500) when viewing the front plate (320) from above.

12. The electronic device (300) of claim 11, wherein the camera module (500) is disposed to be close to or to be in contact with the display panel through the second opening.

## Patentansprüche

1. Elektronische Vorrichtung (300), umfassend:
eine vordere Platte (320);
ein Anzeigefeld, das in einem Innenraum (3001) der elektronischen Vorrichtung (300) angeordnet ist, das durch zumindest einen Abschnitt der vorderen Platte (320) sichtbar ist; und
ein Kameramodul (500), das in dem Innenraum (3001) angeordnet ist und einen Bildsensor (540) beinhaltet, der nahe dem Anzeigefeld angeordnet ist,
wobei das Anzeigefeld Folgendes umfasst:
einen ersten Bereich (DA1) mit einer ersten Pixeldichte,
einen zweiten Bereich (DA2), der von dem ersten Bereich (DA1) umgeben ist und eine zweite Pixeldichte aufweist, die niedriger als die erste Pixeldichte ist, und
einen dritten Bereich (DA3), der von dem zweiten Bereich (DA2) umgeben ist und eine Mitte des Bildsensors (540) zumindest teilweise überlappt, wenn die vordere Platte (320) von oben betrachtet wird, wobei der dritte Bereich (DA3) eine dritte Pixeldichte aufweist, die niedriger als die zweite Pixeldichte ist;
wobei der dritte Bereich einen Kameraexpositionsbereich umfasst, in dem ein Blickwinkel einer Linse des Kameramoduls im Wesentlichen gebildet wird,
wobei die zweite Pixeldichte des zweiten Bereichs als ein Anteil der ersten Pixeldichte des ersten Bereichs kleiner als 1-(0,1/optische Mindestdurchlässigkeit einer Linse (530) des Kameramoduls (500)) bestimmt wird;
wobei, wenn ein Abstand einer virtuellen geraden Linie von der Mitte des Bildsensors (540) zu einer diagonalen Ecke des Bildsensors (540) als 1F definiert ist, der zweite Bereich (DA2) ein Ringbereich mit 0,5 F als kleinen Radius und 1 F als großen Radius ist.

2. Elektronische Vorrichtung (300) nach Anspruch 1, ferner umfassend einen Polarisator (POL), der zwischen der vorderen Platte (320) und dem Anzeigefeld angeordnet ist,
wobei der POL eine erste Öffnung aufweist, die an einer Position gebildet ist, die zumindest das Kameramodul (500) überlappt, wenn die vordere Platte (320) von oben betrachtet wird.

3. Elektronische Vorrichtung (300) nach Anspruch 2, wobei die erste Öffnung an einer Position angeordnet ist, die den zweiten Bereich (DA2) und den dritten Bereich (DA3) überlappt, wenn die vordere Platte (320) von oben betrachtet wird.

4. Elektronische Vorrichtung (300) nach Anspruch 2, wobei die erste Öffnung an einer Position angeordnet ist, die zumindest einen Abschnitt des ersten Bereichs (DA1) teilweise überlappt, wenn die vordere Platte (320) von oben betrachtet wird.

5. Elektronische Vorrichtung (300) nach Anspruch 2, wobei die erste Öffnung mit einem Indexanpassungsmaterial gefüllt ist, um einen Rückgang an optischer Durchlässigkeit, der durch Reflexion des Anzeigefeldes verursacht wird, zu unterdrücken.

6. Elektronische Vorrichtung (300) nach Anspruch 2, wobei die vordere Platte (320) einen gekrümmten Abschnitt aufweist, der in einem Bereich, der die Öffnung überlappt, wenn die vordere Lage von oben betrachtet wird, nach außen vorsteht.

7. Elektronische Vorrichtung (300) nach Anspruch 2, ferner umfassend:
eine erste Kleberschicht, die zwischen der vorderen Platte (320) und dem POL angeordnet ist; und
eine zweite Kleberschicht, die zwischen dem POL und dem Anzeigefeld angeordnet ist.

8. Elektronische Vorrichtung (300) nach Anspruch 7, wobei zumindest eine von der ersten Kleberschicht oder der zweiten Kleberschicht zumindest eines von einem optisch klaren Kleber (OCA), einem druckempfindlichen Kleber (PSA), einem thermisch reaktiven Kleber, einem normalen Kleber oder einem doppelseitigen Band umfasst.

9. Elektronische Vorrichtung (300) nach Anspruch 7, wobei zumindest eine von der ersten Kleberschicht oder der zweiten Kleberschicht ferner ein durchlässiges Beschichtungsmaterial umfasst, das zumindest teilweise angeordnet ist, um einen Rückgang an optischer Durchlässigkeit aufgrund von Reflexion des Anzeigefeldes zu unterdrücken.

10. Elektronische Vorrichtung (300) nach Anspruch 9, wobei das durchlässige Beschichtungsmaterial den zweiten Bereich (DA2) und den dritten Bereich (DA3) überlappt, wenn die vordere Platte (320) von oben betrachtet wird.

11. Elektronische Vorrichtung (300) nach Anspruch 1, ferner umfassend zumindest eine Hilfsmaterialschicht, die auf der Rückseite des Anzeigefeldes angeordnet ist,
wobei die Hilfsmaterialschicht eine zweite Öffnung aufweist, die zumindest das Kameramodul (500) überlappt, wenn die vordere Platte (320) von oben betrachtet wird.

12. Elektronische Vorrichtung (300) nach Anspruch 11, wobei das Kameramodul (500) angeordnet ist, um nahe an oder in Kontakt mit dem Anzeigefeld durch die zweite Öffnung zu sein.

## Revendications

1. Dispositif électronique (300) comprenant :
une plaque avant (320) ;
un panneau d'affichage disposé dans un espace interne (3001) du dispositif électronique (300) visible à travers au moins une partie de la plaque avant (320) ; et
un module de caméra (500) disposé dans l'espace interne (3001) et comprenant un capteur d'image (540) disposé à proximité du panneau d'affichage,
ledit panneau d'affichage comprenant :
une première zone (DA1) comportant une première densité de pixels,
une deuxième zone (DA2) entourée par la première zone (DA1) et comportant une seconde densité de pixels inférieure à la première densité de pixels, et
une troisième zone (DA3) entourée par la deuxième zone (DA2) et chevauchant au moins partiellement le centre du capteur d'image (540) lors de la visualisation de la plaque avant (320) depuis le dessus, ladite troisième zone (DA3) comportant une troisième densité de pixels inférieure à la deuxième densité de pixels ;
ladite troisième zone comprenant une zone d'exposition de caméra dans laquelle un angle de vue d'un objectif du module de caméra est sensiblement formé,
ladite deuxième densité de pixels de la deuxième zone étant déterminée sous la forme d'une proportion de la première densité de pixels de la première zone inférieure à 1-(0,1/transmittance optique minimale d'un objectif (530) du module de caméra (500)) ;
lorsque la distance d'une ligne droite virtuelle depuis le centre du capteur d'image (540) jusqu'à un coin diagonal du capteur d'image (540) est définie comme étant 1 F, ladite deuxième zone (DA2) étant une zone annulaire comportant 0,5 F comme petit rayon et 1 F comme grand rayon.

2. Dispositif électronique (300) selon la revendication 1, comprenant en outre un polariseur (POL) disposé entre la plaque avant (320) et le panneau d'affichage,
ledit POL comportant une première ouverture formée dans une position chevauchant au moins le module de caméra (500) lors de la visualisation de la plaque avant (320) depuis le dessus.

3. Dispositif électronique (300) selon la revendication 2, ladite première ouverture étant disposée dans une position chevauchant la deuxième zone (DA2) et la troisième zone (DA3) lors de la visualisation de la plaque avant (320) depuis le dessus.

4. Dispositif électronique (300) selon la revendication 2, ladite première ouverture étant disposée dans une position chevauchant partiellement au moins une partie de la première zone (DA1) lors de la visualisation de la plaque avant (320) depuis le dessus.

5. Dispositif électronique (300) selon la revendication 2, ladite première ouverture étant remplie d'un matériau d'adaptation d'indice pour supprimer une diminution de la transmittance optique provoquée par la réflexion du panneau d'affichage.

6. Dispositif électronique (300) selon la revendication 2, ladite plaque avant (320) comportant une partie incurvée faisant saillie vers l'extérieur dans une zone chevauchant l'ouverture lors de la visualisation de la feuille avant depuis le dessus.

7. Dispositif électronique (300) selon la revendication 2, comprenant en outre :
une première couche adhésive disposée entre la plaque avant (320) et le POL ; et
une seconde couche adhésive disposée entre le POL et le panneau d'affichage.

8. Dispositif électronique (300) selon la revendication 7, au moins une couche parmi la première couche adhésive ou la seconde couche adhésive comprenant au moins un adhésif parmi un adhésif optique transparent (OCA), un adhésif autocollant (PSA), un adhésif thermiquement réactif, un adhésif normal ou un ruban adhésif double face.

9. Dispositif électronique (300) selon la revendication 7, au moins une couche parmi la première couche adhésive ou la seconde couche adhésive comprenant en outre un matériau de revêtement translucide disposé au moins partiellement pour supprimer une diminution de la transmittance optique due à la réflexion du panneau d'affichage.

10. Dispositif électronique (300) selon la revendication 9, ledit matériau de revêtement translucide chevauchant la deuxième zone (DA2) et la troisième zone (DA3) lors de la visualisation de la plaque avant (320) depuis le dessus.

11. Dispositif électronique (300) selon la revendication 1, comprenant en outre au moins une couche de matériau secondaire disposée sur la face arrière du panneau d'affichage,
ladite couche de matériau secondaire comportant une seconde ouverture chevauchant au moins le module de caméra (500) lors de la visualisation de la plaque avant (320) depuis le dessus.

12. Dispositif électronique (300) selon la revendication 11, ledit module de caméra (500) étant disposé de manière à être proche ou de manière à être en contact avec le panneau d'affichage à travers la seconde ouverture.
